# EUROPÄISCHE PATENTANMELDUNG

(11) **EP 1 804 345 A2**
(43) Veröffentlichungstag der Anmeldung: **04.07.2007**
(21) Anmeldenummer: 07005067.9
(22) Anmeldetag: 03.11.1998
(51) Int. Cl.: H01R 13/658, H01R 13/58, H05H 9/00

(54) **Störstrahlsicheres Bus-Gehäuse**

(30) Priorität: 09.11.1997 DE 29719841 U
(62) Teilanmeldung aus: 98120821.8
(71) Anmelder: Schmitt, Fred R., 74388 Talheim (DE)
(72) Erfinder: Schmitt, Fred R., 74388 Talheim (DE)
(74) Vertreter: Müller, Hans

(57) **Zusammenfassung**

Ein störstrahlsicheres Bus-Gehäuse (10) für einen Steckverbinder (34) besitzt neben einer Öffnung (21) für den Steckverbinder (34) zumindest zwei verschließbare Öffnungen (17, 19), durch die im geöffneten Zustand ein mit dem Steckverbinder zu verbindendes Kabel (70) in seiner Längsrichtung in das Gehäuse (10) hin- beziehungsweise aus dem Gehäuse (10) herausführbar ist. Die Längsachsen (50, 52) der Öffnungen (17, 19) für die Kabel (70) sind in gegenseitiger paralleler oder nahezu paralleler Ausrichtung vorhanden. Das Gehäuse (10) ragt im Bereich dieser beiden Öffnungen (17, 19) nicht über eine Begrenzungslinie (60) hinaus, welche die maximale Ausdehnung des Steckverbinders (34) im Bereich der dieser Begrenzungslinie (60) benachbarten Gehäusewand (18) definiert. Die zwei Öffnungen (17, 19) für die Kabel (70) sind treppenförmig beziehungsweise stufenförmig versetzt zueinander ausrichtet.

## Beschreibung

### TECHNISCHES GEBIET

Die Erfindung betrifft ein störstrahlsicheres Bus-Gehäuse. Ein derartiges Gehäuse besitzt zumindest eine Öffnung für einen Steckverbinder und zwei weitere Öffnungen zum Einführen von elektrischen Kabeln. Die elektrischen Kabel und der Steckverbinder können im Inneren des Gehäuses direkt oder indirekt über eine Leiterplatte miteinander verbunden sein. Derartige Bus-Gehäuse werden oftmals zu mehreren dicht aneinanderliegend plaziert.

### STAND DER TECHNIK

Es sind störstrahlsichere Steckverbinder-Gehäuse bekannt, die auf ihren dem Steckverbinder gegenüberliegenden Gehäusebereichen mit drei Kabeleinlaßöffnungen versehen sind. Neben einer mittigen Öffnung sind links und rechts davon jeweils eine weitere Öffnung vorgesehen. Aus der mittleren Öffnung kann ein Kabel mittig, fluchtend mit den Kontakten des Steckverbinders in das Gehäuse hineingeführt werden. Die beiden anderen zum Einführen eines Kabels vorgesehenen Gehäuseöffnungen sind schräg dazu ausgebildet und in den dazu abgeschrägten Gehäuseecken angeordnet. Das durch eine dieser Öffnungen eingeleitete Kabel verläuft damit schräg zu dem mittig in das Gehäuse hineingeführten Kabel. Sofern die beiden seitlichen Gehäuseöffnungen zum Einführen von zwei Kabeln verwendet werden, ist der gegenseitige Winkel zwischen den beiden schräg ausgerichteten Kabeln V-förmig und doppelt so groß. Zwei in das Gehäuse hineinführende Kabel können dadurch nicht eng anliegend und platzsparend außerhalb des Gehäuses angeordnet werden.

### DARSTELLUNG DER ERFINDUNG

Ausgehend von diesem vorbekannten Stand der Technik liegt der Erfindung die Aufgabe zugrunde, störstrahlsichere Bus-Gehäuse der eingangs genannten Art anzugeben, die möglichst dicht beieinanderliegend angeordnet werden können und bei denen die in das Gehäuse hineingeführten mehreren Kabel eng beieinanderliegend und damit platzsparend unmittelbar außerhalb der Gehäuse plaziert werden können.

Diese Erfindung ist durch die Merkmale des Anspruchs 1 gegeben. Ausgehend von dem im Stand der Technik bekannten störstrahlsicheren Gehäuse zeichnet sich das erfindungsgemäße Bus-Gehäuse durch die im kennzeichnenden Teil des Anspruchs 1 zusätzlich angegebenen Merkmale aus. Bei dem erfindungsgemäßen Gehäuse sind die Längsachsen der zwei für das Hineinführen von Kabeln vorgesehenen Gehäuseöffnungen in gegenseitiger paralleler oder nahezu paralleler Ausrichtung vorhanden. Ferner ragt der diese Öffnungen enthaltende Gehäusebereich nicht über eine gedachte Begrenzungslinie hinaus, welche durch die maximale Ausdehnung des Steckverbinders im Bereich der dieser Begrenzungslinie benachbarten Gehäusewand definiert wird. Die Öffnungen befinden sich damit gleichsam im Lichtraumbereich des durch die Größe des Steckverbinders erforderlichen Gehäuses. Auf diese Weise können mehrere derartige Gehäuse wünschenswert dicht übereinander plaziert werden. Die aus dem Gehäuse in praktisch gleicher Richtung herausführenden Kabel werden durch das jeweils benachbarte Gehäuse nicht gestört. Dadurch können die Kabel platzsparend und montagefreundlich angeordnet werden.

Es hat sich als günstig herausgestellt, die Gehäuseecke, die der Seitenwand mit den beiden Öffnungen für die Kabel gegenüberliegt und die auf der zum Steckverbinder gegenüberliegenden Gehäuseseite vorhanden ist, abzuschrägen. Dadurch kann bei sehr dicht am Steckverbinder plazierten Öffnungen für die Kabel und eng beieinanderliegenden Gehäusen trotzdem eine problemlose Anordnung dieser Kabel in gewünschter gleicher Ausrichtung bei allen Gehäusen vorgesehen werden.

Diese Abschrägung ist vorteilhafterweise parallel oder nahezu parallel zur Längsachse der beiden Öffnungen für die Kabel ausgebildet.

Nach einem auch in der Zeichnung näher dargestellten Ausführungsbeispiel ist der Winkel zwischen den Längsachsen der Öffnungen für die Kabel und der Längsachse für die Öffnung des Steckverbinders 30 Grad groß. Darüber hinaus können die beiden Öffnungen für das Kabel, wie in dem Ausführungsbeispiel zeichnerisch dargestellt ist, treppenförmig versetzt zueinander angeordnet sein.

Sofern eine Leiterplatte im Gehäuse vorgesehen ist, kann dieselbe Klemmbuchsen zum Anschluß des Kabels besitzen. Die Leiterplatte kann bereits fest mit dem Steckverbinder verbunden in dem Gehäuse plaziert werden, so daß Leiterplatten und Steckverbinder beim Zusammenbauen des Gehäuses eine Montageeinheit bilden.

Die Befestigung der Leiterplatte an dem Gehäuse kann über Schraubverbindungen hergestellt werden.

Die zum Einführen der elektrischen Kabel vorgesehenen Öffnungen können einerseits von einem Blindstopfen und andererseits von einem eine zentrale Durchtrittsöffnung aufweisenden Crimpflansch verschlossen werden. Der Crimpflansch besteht dabei aus einer eine Öffnung aufweisenden Schiebeplatte, in der eine Hülse zug-, druckfest und verdrehsicher eingesetzt ist. Der Crimpflansch wird immer dann eingesetzt, wenn ein Kabel durch die betreffende Gehäuseöffnung in das Gehäuse eingeführt werden soll. Blindstopfen und Crimpflansch stellen jeweils ein Einsatzstück dar, das bei entferntem Deckelteil aus Richtung des Deckels in die in den umlaufenden Wandungen des Bodenteils vorhandenen Öffnungen eingesetzt, das heißt eingeschoben werden kann. Das Einsatzstück stößt dann einerseits auf dem Boden des Bodenteils auf und berührt andererseits den auf das Bodenteil aufgeschraubten Deckel. In den dazu gegenüberliegenden Seitenwänden des Einsatzstückes ist eine durch Vorsprünge und Rücksprünge ausgebildete Verzahnung vorhanden, die mit einer entsprechenden Gegen-Verzahnung in den Seitenwänden des Bodenteils korrespondiert. Dadurch weist die Berührfläche zwischen dem jeweiligen Einsatzstück und der Wand zumindest zwei Zick-Zack-Linien auf. Durch diese Hinterschneidungen wird der Berührkontakt zwischen Einsatzstück und Gehäuse sichergestellt, um den elektrischen Widerstand zwischen Einsatzstück und Gehäuse wünschenswert klein zu halten und dadurch einen verbesserten HF-Übergang zwischen Einsatzstück und Gehäuse zu ermöglichen. Jede der Verzahnungen ist mehrstufig, so daß eine wünschenswert große, das heißt vergleichsweise lange Berührfläche zwischen Einsatzstück und Wand ausgebildet wird. Gleichzeitig erhöht diese mehrstufige Zick-Zack-Kontaktfläche auch den Spritzwasserschutz im Bereich zwischen Einsatzstück und Gehäusewand.

Weitere Ausgestaltungen und Vorteile der Erfindung sind den in den Ansprüchen fernerhin aufgeführten Merkmalen sowie dem nachfolgenden Ausführungsbeispiel zu entnehmen.

### KURZE BESCHREIBUNG DER ZEICHNUNG

Die Erfindung wird im folgenden anhand des in der Zeichnung dargestellten Ausführungsbeispiels näher beschrieben und erläutert. Es zeigen:
- Fig. 1: eine perspektivisch auseinandergezogene Darstellung eines erfindungsgemäßen Gehäuses nach der Erfindung,
- Fig. 2: eine Draufsicht auf das Bodenteil des Gehäuses gemäß Fig. 1,
- Fig. 3: eine teilweise geschnittene Seitenansicht des Gehäuses gemäß Fig. 1,
- Fig. 4: eine Ansicht von zwei dicht beieinander plazierten, auf einer Montageplatte angeschraubten Gehäusen gemäß Fig. 1,
- Fig. 5: eine Ansicht eines zum Einführen eines Kabels vorgesehenen, noch keine Hülse enthaltenden Crimpflansches als Einsatzstück für das Gehäuse gemäß Fig. 1,
- Fig. 6: einen Schnitt längs der Linie 6-6 in Fig. 5 und
- Fig. 7: einen Schnitt längs der Linie 7-7 in Fig. 5.

### WEGE ZUM AUSFÜHREN DER ERFINDUNG

Ein störstrahlsicheres Bus-Gehäuse 10 besitzt, wie allgemein üblich bei derartigen Gehäusen, ein in etwa wannenartiges Bodenteil 12 und ein Deckelteil 13.

Das Bodenteil 12 besitzt einen flachen Boden 14, der durch gegenüberliegende Seitenwände 16, 18 eingerahmt wird. In der einen Seitenwand 18 ist eine erste Öffnung 17 und eine zweite Öffnung 19 zum Einführen von Kabeln vorhanden. Die eine Öffnung 17 kann im vorliegenden Fall durch ein Einsatzstück 20 verschlossen werden, das als Blindstopfen und damit als ein die Öffnung 17 verschließendes Teil ausgebildet ist. Die andere Öffnung 19 kann durch ein anderes Einsatzstück 26 verschlossen werden. Umrißmäßig sind die beiden Einsatzstücke 20, 26 gleich ausgebildet, so daß die Einsatzstücke wechselweise in den Öffnungen 17, 19 und damit auch zwei gleiche Einsatzstücke in beiden Öffnungen eingesetzt werden können. Im vorliegenden Fall ist das Einsatzstück 26 zum Einführen eines elektrischen Kabels in das Innere des Gehäuses 10 vorgesehen. Das Einsatzstück 26 besitzt eine Schiebeplatte 25 mit einer zentralen Öffnung 27, die durch die unterschiedlich große Durchgangsöffnung einer in der Schiebeplatte 25 zug-, druck- und verdrehsicher einsitzenden Hülse 24 unterschiedlich groß freigegeben wird. Schiebeplatte 25 und Hülse 24 werden als Crimpflansch bezeichnet. Beide Einsatzstücke 20, 26 sitzen im eingebauten Zustand mittels einer mehrstufigen Verzahnung in der Seitenwand 18 von oben drin. Die Einsatzstücke sitzen dann mit Preßsitz in der Öffnung 17 beziehungsweise 19.

In den Seitenwänden 16, 18 sind Wandverbreiterungen mit einem Innengewinde 28 vorhanden. Das Deckelteil 13 besitzt den Innengewinden entsprechende Bohrungsöffnungen 30, so daß das Deckelteil 13 mittels Schrauben 32 durch die Öffnungen 30 hindurch in den Innengewinden 28 des Bodenteils angeschraubt werden kann.

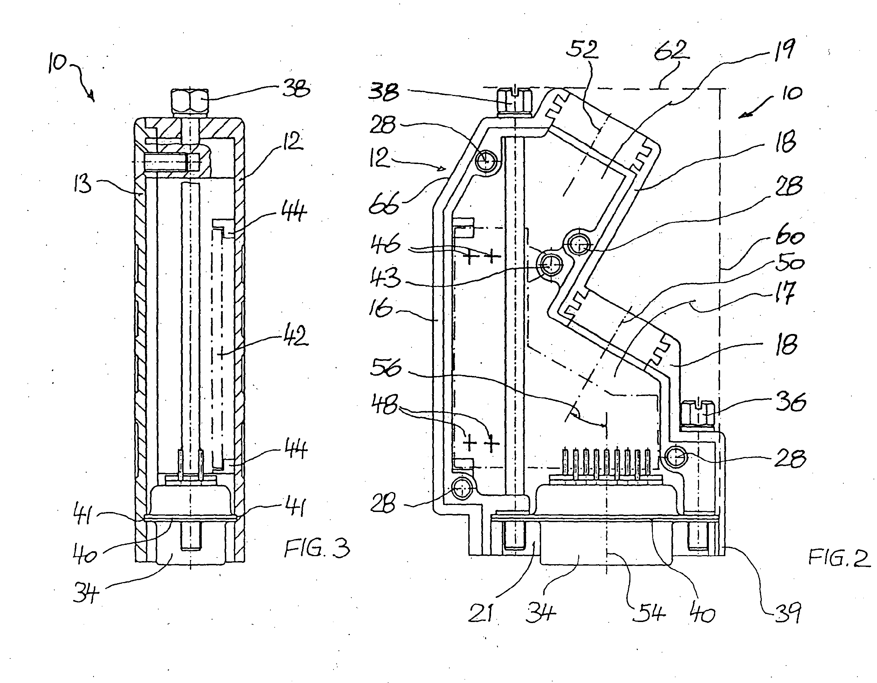

Auf der den Öffnungen 17, 19 entgegengesetzten, unteren Seite des Gehäuses 10 ist eine weitere Öffnung 21 vorhanden, in der ein Steckverbinder 34 plaziert werden kann. Der Steckverbinder 34 sitzt mit seinem umlaufenden Kranz 40 in Nuten 41 (Fig. 3), die im Bodenteil 12 und Deckelteil 13 eingeformt sind. Sollten keine derartigen Nute 41 vorhanden sein, könnte der Steckverbinder auch mittels der Schrauben 36, 38, die durch das Bodenteil 12 längs hindurchgehen, an dem Bodenteil 12 befestigt werden.

Die die Öffnungen 17, 19 aufweisende Seitenwand 18 ragt mit einem unteren Wandlappen 39 über den umlaufenden Kranz 40 des Steckverbinder 34. Entsprechendes gilt auch für die Wand 16. Dadurch ist der Kranz 40 umlaufend eingerahmt, einerseits durch die Wände 16 und den Wandlappen 39 der Wand 18 sowie durch den Boden 14 und das Deckelteil 13.

Diese vollständige Einrahmung des Kranzes 40 auch im Bereich der Wände 16, 18 stellt eine Erhöhung der Störstrahlsicherheit dar. Sollte eine derartige hohe Störstrahlsicherheit nicht erforderlich sein, könnte auf das Einrahmen des Steckverbinders 34 im Bereich der Wände 16, 18 und damit beispielsweise auf das Anordnen des Wandlappens 39 auch verzichtet werden.

Im Inneren des Bodenteils 12 ist eine Leiterplatte 42 vorhanden, die in Fig. 2 und 3 strichpunktiert angedeutet ist. Die Leiterplatte 42 ruht auf Sockeln 44, die am Boden 14 befestigt sind. Zusätzlich ist die Leiterplatte 42 über nicht näher dargestellte Verdrahtungen mit dem Steckverbinder 34 verbunden. Die dem Innenraum des Bodenteils 12 in etwa angepaßte Leiterplatte ist so ausreichend stabil, einerseits durch Auflagerung auf den Sockeln 44 und zum anderen durch die Befestigung an dem Steckverbinder 34, gehalten. Im vorliegenden Fall ist die Leiterplatte 42 unterhalb der in Fig. 2 linken, längeren Schraube 38 plaziert. Außerdem ist die Leiterplatte an einer Verschraubungsstelle 43 am Bodenteil 12 befestigt.

In der Leiterplatte 42 sind - bezogen auf die Darstellung in Fig. 2 - zwei obere und zwei untere Anschraubstellen 46, 48 für die durch die Öffnungen 17 beziehungsweise 19 hineingeführten Adern von Kabeln vorgesehen. Diese Anschraubstellen sind innerhalb von nicht näher dargestellten Blöcken vorhanden, die an diesen Stellen auf der Leiterplatte 42, zwischen der Seitenwand 16 und der Schraube 38, befestigt sind. Ein beispielsweise durch die obere Öffnung 19 hineingeführtes Kabel kann dadurch an den Anschraubstellen 46 oder auch an den Anschraubstellen 48 befestigt werden.

Die Öffnungen 17 und 19 sind mit ihren Längsachsen 50, 52 parallel zueinander ausgerichtet und weisen mit der durch den Steckverbinder 34 vorgegebenen Längsachse 54 einen gleichen Winkel 56 von im vorliegenden Beispielsfall 30 Grad auf. Die beiden Öffnungen 17, 19 sind treppenförmig beziehungsweise stufenförmig versetzt in der Seitenwand 18 ausgebildet. Die Bereiche der Seitenwand 18 sind im Bereich dieser Öffnungen 17, 19 so weit in Richtung der gegenüberliegenden Seitenwand 16 zurückgesetzt und damit in den Innenraum des Bodenteils 12 hineinverschwenkt, daß sie nicht über eine seitliche Begrenzungslinie 60 hinausragen. Diese Begrenzungslinie 60 stellt die Begrenzung der seitlichen Erstreckung des Kranzes 40 vom Steckverbinder 34 im Bereich dieser Seitenwand 18 dar. Die Begrenzungslinie 60 könnte deckungsgleich mit der Außenseite der Seitenwand 18 im Bereich des Steckverbinders 34 sein, wenn diese Seitenwand 18 nicht mit dem Wandlappen 39 ausgebildet wäre.

Im dem Steckverbinder 34 gegenüberliegenden Bereich des Bodenteils 12 ist das Bodenteil 12 im Bereich der Öffnung 19 durch eine Begrenzungslinie 62 begrenzt. Diese Begrenzungslinie 62 wird durch die Länge der Schraube 38 vorgegeben.

Die Wand 16 besitzt in ihrem oberen, dem Steckverbinder 34 entfernteren Ende eine Abschrägung 66. Die Abschrägung 66 verläuft im vorliegenden Fall parallel zur Ausrichtung der Längsachsen 50, 52. Eine der Abschrägung 66 entsprechende Abschrägung 67 ist im Deckelteil 13 vorhanden. Das Deckelteil 13 entspricht umrißmäßig dem Umriß des Bodenteils 12.

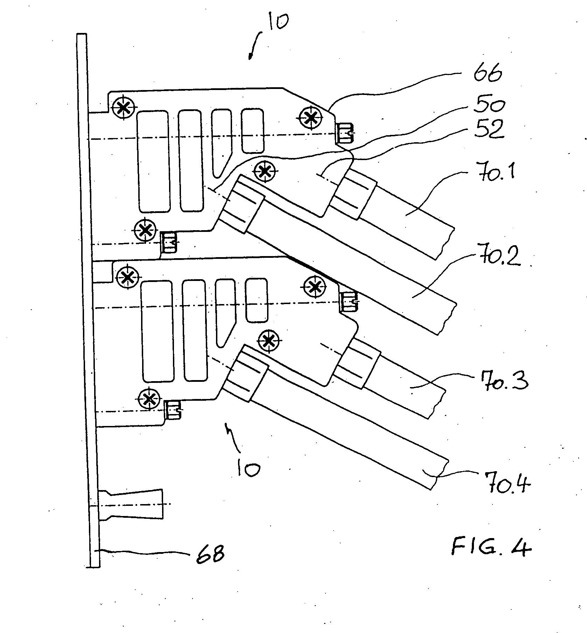

In Fig. 4 sind zwei dicht beieinander auf einer Montageplatte 68 angeschraubte Gehäuse 10 dargestellt. In das obere Gehäuse 10 führen zwei Kabel 70.1 und 70.2 hinein. In das untere Gehäuse führen ebenfalls zwei Kabel 70.3 und 70.4 hinein. Aufgrund der parallelen Ausrichtung der Längsachsen 50, 52 der betreffenden Öffnungen in den beiden Gehäusen liegen alle vier Kabel parallel zueinander. Aufgrund der Abschrägung 66 stört das im vorliegenden Beispielsfall untere Gehäuse 10 nicht die gradlinige Führung des unteren Kabels 70.2 des unteren Gehäuses 10 (Fig. 4). Auch der Kopf der Schraube 38 ist so weit seitlich zurückgesetzt vorhanden, daß er die gradlinige Führung des an ihm vorbeiführenden Kabels 70.2 nicht behindert.

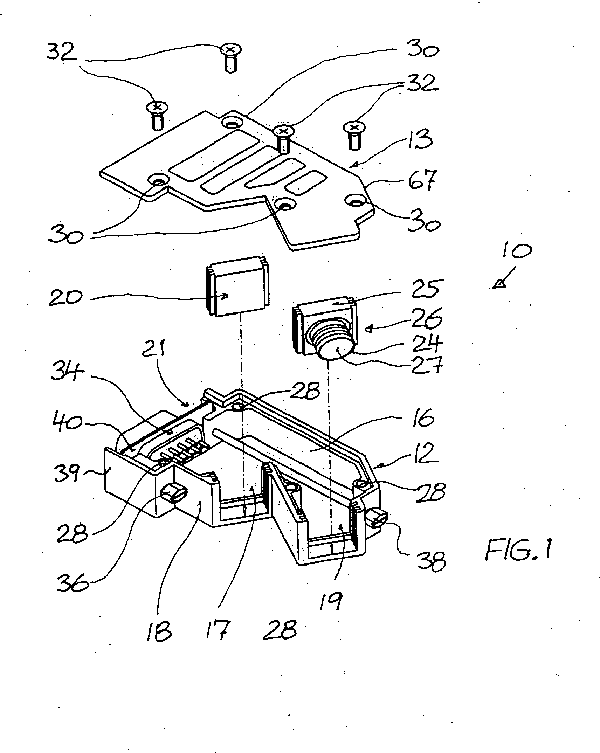

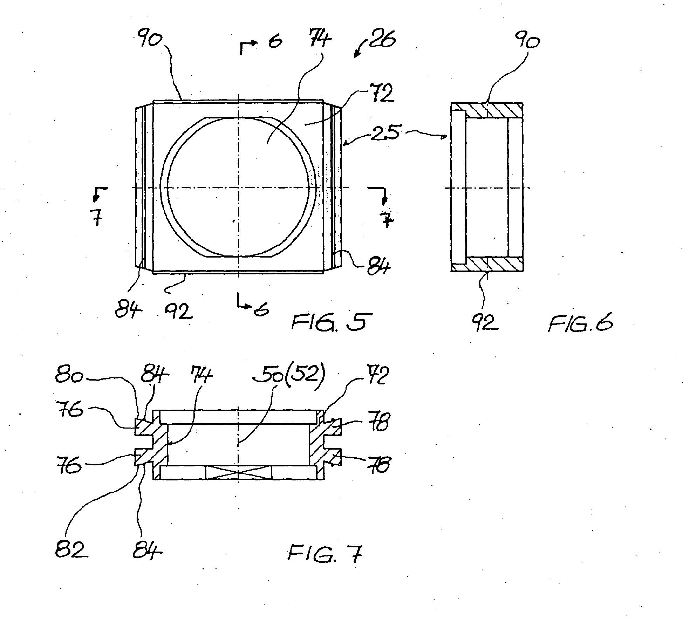

In den Figuren 5 bis 7 ist beispielhaft das Einsatzstück 26 dargestellt, durch das hindurch ein Kabel 70.1 bis 70.4 in das betreffende Gehäuse 10 hineingeführt werden kann. Bei dem Einsatzstück 26 ist nur dessen Schiebeplatte 25 ohne eingesetzte Hülse 24 (vgl. Fig. 1) dargestellt. Das Einsatzstück 26 ist bezogen auf die Darstellung in Fig. 4 in beiden Öffnungen 17, 19 der betreffenden Gehäuse 10 vorhanden.

Das Einsatzstück 26 beziehungsweise die Schiebeplatte 25, besitzt einen quaderförmigen Körper 72, der ringförmig, mit einer zentralen Öffnung 74 ausgebildet ist. Seitlich vom Körper 72 ragen auf seinen gegenüberliegenden Seiten jeweils Vorsprünge 76, 78 aus, die jeweils eine mehrstufige Verzahnung mit den angrenzenden Bereichen der Seitenwand 18 bilden. Jeder Vorsprung 76, 78 besitzt eine vom Körper 72 wegführende und eine zurückführende Zick-Zack-Fläche. Jeder dieser Vorsprünge 76, 78 weist auf seinen vom Körper 72 auskragenden Seitenflächen 80, 82 Längsrippen 84 auf. Im vorliegenden Fall sind diese Seitenflächen 80, 82 schräg zur Längsachse 50 beziehungsweise 52 der Öffnungen 17 und 19 ausgerichtet. Sofern die beiden Vorsprünge 76 beziehungsweise 78 einen gegenseitigen Kontakt hätten, wäre durch jeweils zwei Vorsprünge 76 beziehungsweise 78 eine Art Schwalbenschwanzausbildung gegeben. Im vorliegenden Fall ist diese Schwalbenschwanzausbildung jeweils halb - einerseits durch den oberen Vorsprung 76 und andererseits durch den unteren Vorsprung 78 - ausgebildet. Die beiden Vorsprünge 76 beziehungsweise 78 können auch rechtwinklig von der Längsachse 50 auskragende Seitenwände besitzen. Es ist auch möglich, jeden Vorsprung schwalbenschwanzförmig auszubilden. Wichtig ist in jedem Fall, daß eine mehrstufige Verzahnung zwischen dem Einsatzstück und der Gehäusewand 18 ausgebildet werden kann. Das Einsatzstück 26 sitzt dabei mit Preßsitz in der Öffnung 17 beziehungsweise 19. Die Längsrippen 84 graben sich dabei zumindest geringfügig in die benachbarte Berührungsfläche der Seitenwand 18 ein. Auf der Ober- und Unterseite des Einsatzstückes 26 ist jeweils eine Querrippe 90 beziehungsweise 92 vorhanden. Diese Querrippe 90, 92 berührt einerseits den Boden 14 vom Bodenteil 12 und andererseits die Unterseite des Deckels 13. Das Einsatzstück 26 ist auf diese Weise mit allen seinen vier Umfangsflächen berührungsdicht mit dem Gehäuse 10, das heißt mit dem Bodenteil 12 und dem Deckelteil 13 verbunden.

## Patentansprüche

1. Störstrahlsicheres Bus-Gehäuse (10) für einen Steckverbinder (34),
- mit zumindest zwei verschließbaren Öffnungen (17, 19), durch die im geöffneten Zustand ein mit dem Steckverbinder zu verbindendes Kabel (70) in seiner Längsrichtung in das Gehäuse (10) hin- beziehungsweise aus dem Gehäuse (10) herausführbar ist,
- mit einer weiteren Öffnung (21) für den Steckverbinder (34),
- wobei die Längsachsen (50, 52) der Öffnungen (17, 19) für die Kabel (70) zu der Längsache (54) der Öffnung (21) für den Steckverbinder (34) jeweils einen Winkel (56) größer Null Grad und kleiner 90 Grad besitzen,
**dadurch gekennzeichnet , daß**
- die Längsachsen (50, 52) von zwei Öffnungen (17, 19) für die Kabel (70) in gegenseitiger paralleler oder nahezu paralleler Ausrichtung vorhanden sind,
- das Gehäuse (10) im Bereich dieser beiden Öffnungen (17, 19) nicht über eine Begrenzungslinie (60) hinausragt, welche die maximale Ausdehnung des Steckverbinders (34) im Bereich der dieser Begrenzungslinie (60) benachbarten Gehäusewand (18) definiert,
- die zwei Öffnungen (17, 19) für die Kabel (70) treppenförmig beziehungsweise stufenförmig versetzt zueinander ausgerichtet sind.

2. Gehäuse nach Anspruch 1,
**dadurch gekennzeichnet, daß**
- die Gehäuseecke, die der Seitenwand (18) mit den beiden Öffnungen (17, 19) für die Kabel (70) gegenüberliegt und die auf der zum Steckverbinder (34) gegenüberliegenden Gehäuseseite vorhanden ist, eine Abschrägung (66) besitzt.

3. Gehäuse nach Anspruch 2,
**dadurch gekennzeichnet , daß**
- die Abschrägung (66) parallel oder nahezu parallel zur Längsachse (50, 52) der beiden Öffnungen (17, 19) für die Kabel (70) ausgebildet ist.

4. Gehäuse nach einem der vorstehenden Ansprüche,
**dadurch gekennzeichnet, daß**
- der Winkel (56) zwischen den Längsachsen (50, 52) der Öffnungen (17, 19) für die Kabel (70) und der Längsachse (54) der Öffnung (21) für den Steckverbinder (34) etwa 30 Grad beträgt.

5. Gehäuse nach einem der vorstehenden Ansprüche,
**dadurch gekennzeichnet, daß**
- eine Leiterplatte (42) im Gehäuse (10) vorhanden ist,
- diese Leiterplatte (42) mit dem Steckverbinder (34) und mit den Kabeln (70) elektrisch leitend zu verbinden ist.

6. Gehäuse nach einem der vorstehenden Ansprüche,
**dadurch gekennzeichnet , daß**
- die Leiterplatte (42) fest mit dem Steckverbinder (34) verbunden ist, so daß
- die Leiterplatte (42) und Steckverbinder (34) eine Montageeinheit bilden.

7. Gehäuse nach einem der vorstehenden Ansprüche,
**dadurch gekennzeichnet , daß**
- die Leiterplatte (42) an dem Gehäuse sockelartig aufsetzbar und/oder anschraubbar ist.

8. Gehäuse nach einem der vorstehenden Ansprüche,
**dadurch gekennzeichnet, daß**
- jeweils ein Einsatzstück (20, 26) in die für die Kabel vorgesehenen Öffnungen (17, 19) einsetzbar ist,
- dieses Einsatzstück (20, 26) ein die Öffnung (17, 19) verschließender Blindstopfen oder eine eine Öffnung besitzende Schiebeplatte ist,
- das Einsatzstück (20, 26) Vorsprünge (76, 78) aufweist, die mit Rücksprüngen in dem Gehäuse (10) derart korrespondieren, daß das Einsatzstück (20, 26) längs der Rücksprünge in dem Gehäuse, die für ihn Längsführungen darstellen, in das Gehäuse einschiebbar ist,
- zwischen Einsatzstück und Gehäuse eine mehrstufige Verzahnung vorhanden ist.

9. Gehäuse nach Anspruch 8,
**dadurch gekennzeichnet, daß**
- an den Vorsprüngen (76, 78) Längsrippen (84) vorhanden sind.

10. Gehäuse nach Anspruch 8 oder 9,
**dadurch gekennzeichnet, daß**
- eine Querrippe (90, 92) auf zumindest einer der nicht Vorsprünge (76, 78) aufweisenden Außenfläche des Einsatzstückes (20, 26) vorhanden ist.
